# EUROPÄISCHE PATENTSCHRIFT

(11) **EP 2 491 410 B1**
(45) Veröffentlichungstag und Bekanntmachung des Hinweises auf die Patenterteilung: **12.07.2017**
(21) Anmeldenummer: 10767930.0
(22) Anmeldetag: 04.10.2010
(51) Int. Cl.: G01R 29/00, G01R 31/00, G01R 31/40, G01R 31/42, H02M 5/458, H02M 7/797, G01R 19/06, G01R 31/28

(54) **AUS EINEM ELEKTRISCHEN WECHSELSTROMNETZ VERSORGBARES ELEKTROGERÄT UND VERFAHREN ZUR FEHLERERKENNUNG**
ELECTRICAL APPLIANCE WHICH CAN BE SUPPLIED BY AN AC POWER NETWORK AND FAULT DETECTION METHOD
APPAREIL ÉLECTRIQUE POUVANT ÊTRE ALIMENTÉ À PARTIR D'UN RÉSEAU ÉLECTRIQUE À COURANT ALTERNATIF ET PROCÉDÉ DE DÉTECTION D'ERREUR

(30) Priorität: 19.10.2009 DE 102009049934
(43) Veröffentlichungstag der Anmeldung: 29.08.2012
(73) Patentinhaber: SEW-EURODRIVE GmbH & Co. KG, 76646 Bruchsal (DE)
(72) Erfinder: SCHULLERUS, Gernot, 72768 Reutlingen (DE); STAMM, Walter, 68789 St. Leon-Rot (DE)
(86) Internationale Anmeldenummer: PCT/EP2010/006045
(87) Internationale Veröffentlichungsnummer: WO 2011/047784

(56) Entgegenhaltungen:
- EP-A1- 0 662 615
- EP-A1- 2 219 041
- EP-A2- 0 353 569
- EP-A2- 0 692 757
- EP-A2- 1 909 368
- WO-A1-98/34335
- DE-A1- 2 829 588
- DE-A1- 3 738 180
- DE-A1- 10 135 286
- DE-A1- 19 642 596
- DE-A1- 19 909 706
- DE-A1-102004 035 799
- FR-A1- 2 362 402
- US-A1- 2001 040 458
- US-A1- 2009 072 982

## Beschreibung

Die Erfindung betrifft ein aus einem elektrischen Wechselstromnetz versorgbares Elektrogerät und ein Verfahren zur Fehlererkennung.

Es ist bekannt, Vorrichtungen mit einer rückspeisefähigen Versorgungseinheit auszustatten. Beispielsweise werden in der Solartechnik oder in der Antriebstechnik erzeugte Energieflüsse ins öffentliche elektrische Versorgungsnetz rückgespeist.

Aus der EP 0 353 569 A2 ist bekannt, einen Umrichter eingangsseitig mit einer Arbeitsdrossel auszustatten, wobei die Arbeitsdrossel durch in den Netzphasenzuleitungen angeordneten Induktivitäten ausgeführt wird. Dabei wird der Strom netzseitig an der Arbeitsdrossel und die Spannung umrichterseitig an der Arbeitsdrossel erfasst. Die erfassten Stromsignale und Spannungssignale werden einer Steuereinrichtung zugeführt, welche die Ansteuersignale der Schalter der Endstufe des Umrichters erzeugt.

Aus der DE 37 38 180 A1 ist ein Verfahren zur Regelung der Ausgangsgleichspannung eines selbstgeführten Netzstromrichters bekannt.

Aus der DE 199 09 706 A1 ist ein Verfahren zur Abbildung der Netzspannung bei rückspeisefähigen Versorgungsgeräten bekannt.

Aus der WO 98/34335 A1 ist eine Regelungsanordnung zur Rückspeisung von Energie aus einem Drehstromnetz in einem Umrichter mit Spannungszwischenkreis bekannt.

Aus der EP 0 692 757 A2 ist eine Schaltungsanordnung zum Liefern von Speisespannungen bekannt.

Aus der EP 1 909 368 A2 ist eine Schaltungsanordnung zur Isolationsüberwachung für Umrichteranwendungen bekannt.

Aus der DE 28 29 588 A1 ist eine Prüfeinrichtung für Elektrizitätszähler bekannt.

Aus der EP 0 662 615 A1 ist ein Verfahren zur Kurzschlusserkennung in Bahnnetzen bekannt.

Aus der US 2001 / 0 040 458 A1 ist eine Vorrichtung zum Erkennen eines Störlichtbogens bekannt.

Aus der FR 2 362 402 A1 ist eine Vorrichtung zur Überwachung einer Wechselgröße bekannt.

Aus der EP 2 219 041 A1 ist ein robustes Fehlererkennungssystem bekannt, das PWM Seitenbänder benutzt.

Aus der DE 101 35 286 A1 ist ein Verfahren zur Überbrückung von kurzzeitigen Netzausfällen bei einem Matrixumrichter bekannt.

Aus der DE 196 42 596 A1 ist ein Verfahren zur Kompensation von Blindstromanteilen mittels einer Kompensationseinrichtung mit einem Pulsstromrichter bekannt.

Aus der DE 10 2004 035 799 A1 ist ein Frequenzumrichter mit einem kondensatorlosen Zwischenkreis bekannt.

Der Erfindung liegt die Aufgabe zugrunde, die Rückspeisung weiterzuentwickeln, so dass bestimmte Fehler schnell erkennbar sind.

Erfindungsgemäß wird die Aufgabe bei dem Elektrogerät nach den in Anspruch 1 und bei dem Verfahren nach den in Anspruch 9 angegebenen Merkmalen gelöst.

Wichtige Merkmale der Erfindung bei dem aus einem elektrischen Wechselstromnetz versorgbaren Elektrogerät sind, dass zumindest eine Netzphasenspannung erfasst und einem Filter zugeführt wird, dessen Ausgangssignal einer Auswerteeinheit zugeführt wird, der auch das erfasste Spannungssignal zugeführt wird.

Von Vorteil ist dabei, dass die erfassten Spannungswerte mit Referenzwerten verglichen werden, die durch Bandpassfilterung erzeugt werden. Somit ist ein schnelles Erkennen von Fehlern, wie Netzausfall oder Netzphasenausfall möglich.

Ein weiterer Vorteil ist auch, dass mittels der Filterung, insbesondere der Bandpassfilterung die Grundschwingung der Netzspannung ohne weiteren Aufwand zur Verfügung steht, so dass diese auch in der Regelung der Vorrichtung, insbesondere im Stromregler eines umfassten Umrichters, verwendbar ist. Außerdem liefert die Erfindung auch einen Wert der Netzfrequenz, welcher somit ebenfalls weiter bei Verfahren zum Regeln der Vorrichtung verwendbar ist.

Bei einer vorteilhaften Ausgestaltung ist das Netz ein einphasiges Netz oder ein Drehstromnetz. Von Vorteil ist dabei, dass die Vorrichtung und das Verfahren unabhängig von der Phasenzahl des Netzes anwendbar ist. Sie ist also sogar für mehrphasige Netze anwendbar.

Bei einer vorteilhaften Ausgestaltung werden alle Netzphasenspannungen erfasst und jeweiligen Filtern zugeführt, deren Ausgangssignale jeweils einer Auswerteeinheit zugeführt werden, der auch die erfassten Netzphasenspannungswerte zugeführt werden. Von Vorteil ist dabei, dass eine Überwachung auf Netzfehler ausführbar ist und eine besonders hohe Reaktionsgeschwindigkeit erreichbar ist, da ein Vergleich mit Referenzwerten ausführbar ist. Da die Referenzwerte langsamer reagieren als die erfassten Spannungswerte ist eine störsichere Fehlererkennung ausführbar.

Bei einer vorteilhaften Ausgestaltung ist ein Bestimmungsmittel zur Bestimmung eines Spannungsraumzeigers aus den erfassten Spannungswerten, der als komplexer Vektor darstellbar ist, vorgesehen,
wobei Realteil und Imaginärteil dieses Vektors als Spannungswerte einem jeweiligen Filter zugeführt werden und die Ausgangssignale einer Auswerteeinheit zugeführt werden, der auch der Realteil und Imaginärteil zugeführt werden. Von Vorteil ist dabei, dass im Wesentlichen die Drehung des Raumzeigers überwachbar ist und bei Abweichungen vom Sollverlauf eine Fehlermeldung auslösbar ist.

Bei einer vorteilhaften Ausgestaltung ist das Filter ein Bandpass beziehungsweise sind die Filter jeweils als Bandpässe ausgeführt, wobei jeder Bandpass eine steuerbare Mittenfrequenz aufweist. Von Vorteil ist dabei, dass der Mittenfrequenzwert dem Wert der Netzfrequenz nachführbar ist. Somit ist die Vorrichtung an verschiedenen Netzfrequenzen betreibbar oder auch an Netzen, deren Frequenz veränderlich ist. Im letztgenannten Fall darf allerdings die Änderung der Netzfrequenz nur langsamer sein als der Reaktionszeit beim Nachführen der Mittenfrequenz entspricht.

Bei einer vorteilhaften Ausgestaltung sind Vergleichsmittel zum Vergleichen der Ausgangssignale des Bandpasses oder der Bandpässe mit den jeweiligen Eingangssignalen der Bandpässe vorgesehen. Die Vergleichsmittel sind mit Bestimmungsmitteln zur Bestimmung einer Regelabweichung verbunden, die einem Regler zugeführt wird, dessen Stellgröße die Mittenfrequenz oder Mittenfrequenzen des Bandpasses oder der Bandpässe ist. Den Vergleichsmitteln werden gefilterte und ungefilterte Komponenten des Spannungsraumzeigers zugeführt, insbesondere Realteil und Imaginärteil, so dass gemäß Additionstheorem oder darauf basierenden mathematischen Operationen die Phase oder ein der Phase entsprechender Wert bestimmbar ist. Von Vorteil ist dabei, dass eine einfache mathematische Darstellung und Auswertung verwendbar ist, da nur eine Lineartransformation der erfassten Spannungswerte zur Bestimmung von Realteil und Imaginärteil notwendig ist. Somit ist auch nur wenig Rechenleistung notwendig. Dies gilt auch für die Operationen innerhalb der Vergleichsmittel, so dass eine Ausführung in Echtzeit ermöglicht ist.

Bei einer vorteilhaften Ausgestaltung ist die rückspeisefähige Versorgungseinheit als Gleichrichter, insbesondere Drehstromgleichrichter, wirksam, insbesondere bei Versorgung aus dem Netz,
wobei aus der gleichgerichteten Spannung ein oder mehrere, von der Vorrichtung umfasste Wechselrichter versorgt sind, mit dem oder denen jeweilige Elektromotoren gespeist sind. Von Vorteil ist dabei, dass die Vorrichtung als Umrichter ausführbar ist, so dass die Drehzahl der gespeisten Elektromotoren regelbar ist. Da aus der gleichgerichteten Spannung mehrere Elektromotoren versorgbar sind, sind die jeweils generatorisch erzeugten Energieflüsse über diesen durch die gleichgerichtete Spannung dargestellten Zwischenkreis den motorisch arbeitenden Elektromotoren zuführbar. Nur falls die motorisch benötigen Energieflüsse geringer als die generatorisch erzeugten Energieflüsse sind, ist eine Rückspeisung ins Netz zu aktivieren. Vorzugsweise ist am Zwischenkreis ein Energiespeicher zur Pufferung vorgesehen.

Bei einer vorteilhaften Ausgestaltung ist zwischen Versorgungseinheit und versorgendem elektrischen Netz ein Netzfilter angeordnet, wobei im Netzfilter jeder Netzphase eine als Induktivität wirksame Wicklung zugeordnet ist und die Wicklungen auf einem Kern derart angeordnet sind, dass eine stromkompensierte Netzdrossel gebildet ist. Von Vorteil ist dabei, dass zwischen den Spannungserfassungsmitteln und der Versorgungseinheit ein elektronisches Bauteil vorgesehen ist, so dass der rückgespeiste Energiefluss nicht direkt spannungserhöhend wirkt sondern indirekt. Somit ist die Rückspeisung möglichst gut phasenrichtig ausführbar. Die stromkompensierte Netzdrossel wirkt bei der Rückspeisung besonders vorteilhaft.

Insbesondere werden an der dem Netz abgewandten Seite der Induktivität ein oder mehrere Phasenströme erfasst,
wobei die erfassten Stromwerte und die erfassten Spannungswerte auch einer Steuerelektronik zugeführt werden, die pulsweitenmodulierte Ansteuersignale erzeugt, die ansteuerbaren Halbleiterschaltern zugeführt werden, welche in einer aus Halbbrücken von Halbleiterschaltern gebildeten Rückspeiseeinheit angeordnet sind.

Vorzugsweise ist die rückspeisefähige Versorgungseinheit als Gleichrichter, insbesondere Drehstromgleichrichter, wirksam, insbesondere bei Versorgung aus dem Netz,
wobei aus der gleichgerichteten Spannung ein oder mehrere, von der Vorrichtung umfasste Wechselrichter versorgt sind, mit dem oder denen jeweilige Elektromotoren gespeist sind.

Von Vorteil ist dabei, dass die von der Rückspeiseeinheit gestellte Spannung derart stellbar ist, dass ein vorgebbarer Leistungsfluss ins Netz rückspeisbar ist, wofür der netzseitige Strom auf einen entsprechenden Sollwert hin geregelt wird.

Bei einer vorteilhaften Ausgestaltung sind in der Auswerteeinheit Fehlererkennungsmittel vorgesehen, denen die erfassten Spannungssignale und die Ausgangssignale der Filtermittel zugeführt werden. Von Vorteil ist dabei, dass durch einen einfachen Vergleich der gefilterten mit den ungefilterten Signalen eine Fehlererkennung ausführbar ist.

Wichtige Merkmale bei dem Verfahren zur Fehlererkennung bei einer rückspeisefähigen Versorgungseinheit sind, dass ein netzseitiger Spannungsraumzeiger und/oder zumindest eine Komponente eines netzseitigen Spannungsraumzeigers erfasst wird und einem steuerbaren Filter zugeführt wird, dessen Ausgangssignal mit dem erfassten Spannungsraumzeiger beziehungsweise zumindest einer dessen Komponenten verglichen wird und eine Regelabweichung bestimmt wird,
die von einem Regler auf Null hin geregelt wird mittels entsprechender Ansteuerung des Filters durch den Regler,
wobei der erfasste Spannungsraumzeiger oder eine seiner Komponenten mit dem als Ausgangssignal der Filterung zur Verfügung stehenden Spannungsraumzeiger beziehungsweise einer seiner Komponenten verglichen wird und bei Überschreiten einer kritischen Differenz eine Aktion ausgelöst wird,
insbesondere Anzeige eines Fehlers, Melden eines Fehlers, Herausgeben einer Warnung, Stillsetzen der Vorrichtung, sicheres Abschalten oder Herunterfahren der Vorrichtung, Aktivieren eines sicheren Zustandes der Vorrichtung oder dergleichen.

Von Vorteil ist dabei, dass bei jeder Netzfrequenz eine Fehlererkennung in einfacher Weise ausführbar ist, nämlich durch bloßes Vergleichen von gefilterten und ungefilterten Signalen.

Bei einer vorteilhaften Ausgestaltung ist beim steuerbaren Filter eine charakteristische Frequenz als Stellgröße des Reglers steuerbar, insbesondere die Mittenfrequenz des als Bandpass ausgeführten Filters. Von Vorteil ist dabei, dass die Mittenfrequenz der Netzfrequenz nachführbar ist.

Bei einer vorteilhaften Ausgestaltung entspricht die Regelabweichung einer Phasendifferenz. Von Vorteil ist dabei, dass als Stellgröße eine Frequenz, insbesondere die Mittenfrequenz, verwendbar ist.

Wichtig ist also bei der Erfindung, dass das System insgesamt zwei Komponenten hat: Es gibt erstens eine Auswertung, die aus Bandpasseingang und -Ausgang auf einen Fehler schließt, nämlich auf einen Netzausfall oder dergleichen. Hierzu wird vorzugsweise eine konsistenzbasierte Diagnose ausgeführt. Zweitens wird die Mittenfrequenz der Bandpässe mit einer Regelung auf die Netzfrequenz abgestimmt, damit man bei verschiedenen Netzfrequenzen oder variabler Netzfrequenz Fehler erkennen kann.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von Abbildungen näher erläutert:

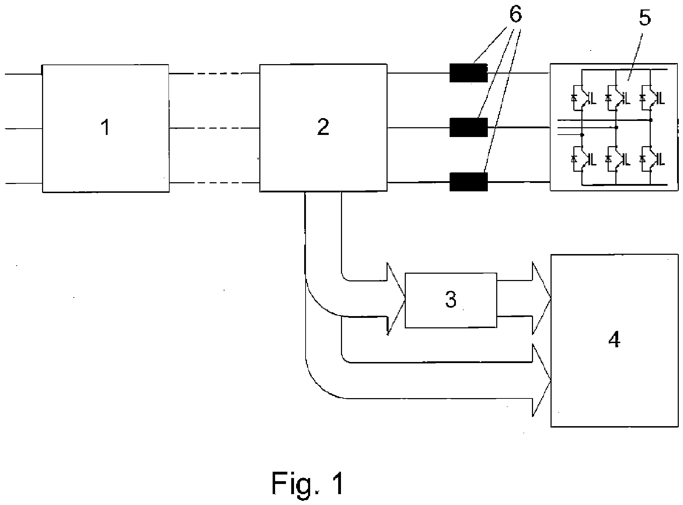

In der Figur 1 ist ein wesentlicher Teile einer erfindungsgemäßen Vorrichtung schematisch skizziert. Dabei weist die Vorrichtung eine rückspeisefähige Versorgungseinheit 5 auf, die drei Halbbrücken umfasst, welche jeweils einen oberen und einen unteren steuerbaren Halbleiterschalter aufweist, wobei jedem Halbleiterschalter zumindest eine Freilaufdiode parallel geschaltet ist. Eingangsseitig wird der rückspeisefähigen Versorgungseinheit 5 eine dreiphasige Versorgungsspannung zugeführt und ausgangsseitig eine unipolare Spannung erzeugt. Denn bei gesperrten Halbleiterschaltern wirkt die rückspeisefähige Versorgungseinheit 5 wie ein Drehstromgleichrichter. Wenn aber nun an der Ausgangsseite ein Energiefluss zugeführt wird, beispielsweise von generatorisch arbeitenden elektrischen Antrieben, ist es ermöglicht, mittels geeigneter pulsweitenmodulierter Ansteuerung der Halbleiterschalter Energie ins eingangsseitige Netz rückzuspeisen.

Eingangsseitig ist ein Netzschütz 1 vorgesehen, mittels dessen die Vorrichtung vom Drehstromnetz abtrennbar ist.

Außerdem ist zwischen Netzschütz 1 und der rückspeisefähigen Versorgungseinheit 5 zumindest eine Induktivitäten umfassende Anordnung, wie Netzfilter oder Netzdrosseln, vorgesehen.

Zwischen Netzschütz 1 und der Induktivitäten umfassenden Anordnung sind Mittel 2 zur Erfassung der Netzspannung vorgesehen. Somit ist die Netzspannung in möglichst direkt, also möglichst wenig von der rückspeisefähigen Versorgungseinheit beeinflusster Art und Weise erfassbar.

Die rückspeisefähige Versorgungseinheit umfasst vorzugsweise mehrere pulsweitenmoduliert ansteuerbare Halbleiterbrücken als Rückspeiseeinheit, wobei eine Steuerelektronik aus den erfassten Werten für Netzspannung und zwischen den Induktivitäten und der Rückspeiseeinheit erfassten Stromwerten die pulsweitenmodulierten Ansteuersignale für die Halbleiterschalter derart bestimmt, dass die gestellte netzseitige Spannung an der Ausgangsseite der Rückspeiseeinheit die erfasste Netzspannung derart überschreitet, dass der somit über die als Stellglied verwendeten Induktivitäten getriebene Strom auf seinen Sollwert hin geregelt wird. Dabei wird der Sollwert aus der ans Netz rückzuspeisenden Leistung bestimmt.

Die erfassten Spannungswerte der einzelnen Netzphasen werden zumindest Bandpassfiltermitteln 3 zugeführt, so dass die entsprechend gefilterten Spannungssignale am Ausgang der Bandpassfiltermittel 3 zur Verfügung stehen. Die Bandpässe weisen hierbei eine einstellbare Mittenfrequenz auf, die mittels einer Regeleinrichtung 23 auf die Netzfrequenz abgestimmt wird. Die Frequenzen des Eingangssignals des jeweiligen Bandpasses werden nur wenig oder gar nicht gedämpft, wenn diese Frequenzen der Mittenfrequenz entsprechen oder benachbart sind. Frequenzen, die weiter entfernt sind, werden stärker gedämpft. Auf diesen Weise ist also die jeweilige Mittenfrequenz auf die vorhandene Netzfrequenz hin regelbar mittels eines Reglers 23. Vorzugsweise ist der Bandpass oder sind die Bandpässe jeweils derart schmalbandig ausgeführt, dass bei sofortigem Netzausfall die Ausgangssignale der Bandpässe mindestens 20ms bis 500 ms, insbesondere 20ms bis 50ms, nur unwesentlich sich verändern, so dass eine Netzausfallerkennung klar ausführbar ist.
Insbesondere sind die Bandpässe derart ausgeführt, dass Abweichungen von 2 % bis 10%, insbesondere 5% bis 10%, schon zu einer Dämpfung von mehr als 3dB führen.

Den Auswertemitteln 4 wird einerseits das jeweilige Ausgangssignal der jeweiligen Bandpassfiltermittel 3 zugeführt und andererseits das jeweilige, mit den Mitteln 2 erfasste Spannungssignal. Somit ist mittels der Auswertemittel 4 ein Vergleich der gefilterten Signale mit den der momentanen Netzspannung entsprechenden Signalen ermöglicht, wobei ein Abschalten der Vorrichtung, eine Warnung oder eine Fehlermeldung auslösbar ist, wenn die gebildete Differenz zwischen dem gefilterten Signal und dem zur entsprechenden Netzphase zugehörigen Signal einen kritischen Betragswert überschreitet.

Alternativ ist auch ein konsistenzbasiertes Diagnoseverfahren anwendbar. Vorzugsweise werden hierbei die gefilterten und ungefilterten Realteile und Imaginärteile ins (U,V,W)-System rücktransformiert und nach vorgebbaren Kriterien verglichen und ausgewertet.

Bei Auftreten eines Netzausfalls oder auch nur eines Ausfalls einer einzigen Netzphase, also eines Netzphasenausfalls, ist somit eine Fehlererkennung und eine entsprechende Aktion auslösbar. Dabei wird vorzugsweise ausgenutzt, dass das Ausgangssignals des Bandpasses auf einen Netzausfall beziehungsweise auf einen Netzphasenausfall nur verzögert reagiert und die mit den Mitteln 2 erfassten Spannungssignale auf den Ausfall schneller reagieren.

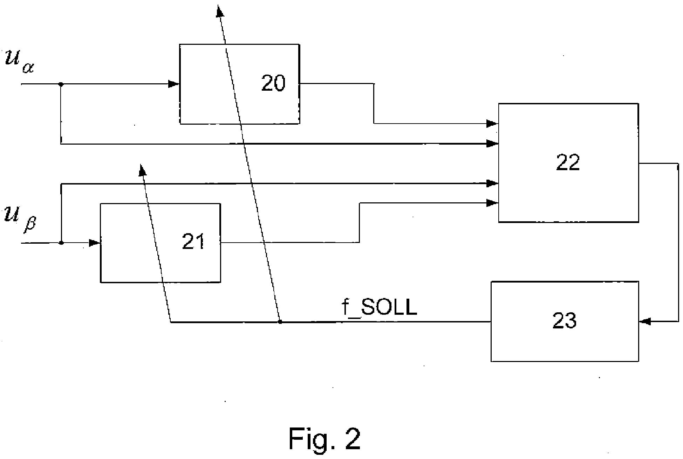

In Figur 2 ist die Regelstruktur zur Einstellung der Mittenfrequenz des Bandpasses näher dargestellt.

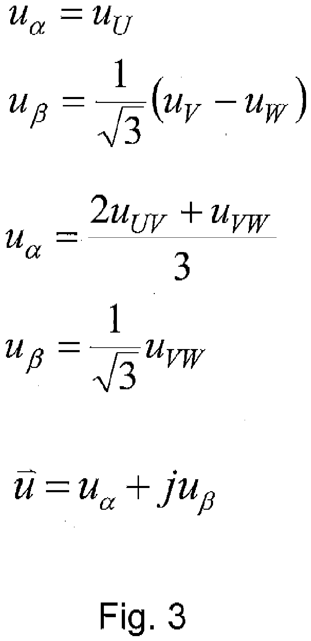

Wie in Figur 3 gezeigt, wird aus den drei, mit den Mitteln 2 erfassten Spannungswerten ein Spannungsraumzeiger bestimmt, insbesondere durch Lineartransformation. Dieser ist als komplexer Vektor darstellbar und weist einen Realteil u_α und einen Imaginärteil u_β auf. Realteil und Imaginärteil werden einem jeweiligen Bandpass (20, 21) zugeführt, wobei die Mittenfrequenz der Bandpässe vom Regler 23 gesteuert wird. Die Ausgangssignale der Bandpässe werden den Mitteln 22 zur Erfassung der Phasendifferenz bezüglich der ungefilterten Signale, also Realteil u_α und Imaginärteil u_β, zugeführt.

Die Mittel 22 erfassen also die Phasendifferenz und führen diese als Regelabweichung dem Regler 23 zu, der somit die Mittenfrequenz derart regelt, dass die Regelabweichung möglichst verschwindet. Somit wird also die jeweilige Mittenfrequenz der Bandpässe auf die Netzfrequenz hin geregelt.

Figur 3 zeigt den mathematischen Zusammenhang zwischen Realteil u_α und Imaginärteil u_β und den einzelnen erfasst Netzphasenspannungswerten u_U, u_V, u_W gegenüber einem Bezugspotential. Die Spannungen zwischen den Netzphasen sind u_UV = u_U - u_V beziehungsweise u_VW = u_V - u_W.

Die Erfindung ist auch auf andere Elektrogeräte anwendbar, wie beispielsweise Umrichter ohne Rückspeisung.

### Bezugszeichenliste

1 Netzschütz
2 Mittel zur Erfassung der Netzspannung
3 Bandpassfiltermittel
4 Auswertemittel
5 rückspeisefähige Versorgungseinheit
6 Induktivitäten umfassende Anordnung, wie Netzfilter oder Netzdrossel
20 Bandpass
21 Bandpass
22 Mittel zur Erfassung der Phasendifferenz als Regelabweichung
23 Regler

## Patentansprüche

1. Aus einem elektrischen Wechselstromnetz versorgbares Elektrogerät umfassend:
- Mittel (2) zur Erfassung der Netzphasenspannungswerte,
- Auswertemittel (4) zum Empfang der mit dem Mittel (2) erfassten Netzphasenspannungswerte, und
- Bandpassfiltermittel (3) zum Empfang der mit dem Mittel (2) erfassten Netzphasenspannungswerte, wobei das Bandpassfiltermittel (3) eine Mittenfrequenz aufweist,
**dadurch gekennzeichnet, dass**
- das Elektrogerät eine Vorrichtung mit rückspeisefähiger Versorgungseinheit ist, wobei die Versorgungseinheit mit dem versorgenden elektrischen Netz über mindestens eine Induktivität verbunden ist und wobei die Netzphasenspannung netzseitig von der Induktivität erfasst wird,
- das Elektrogerät weiterhin umfasst:
Bestimmungsmittel zur Bestimmung eines Spannungsraumanzeigers aus den erfassten Netzphasenspannungswerten, der als komplexer Vektor darstellbar ist,
wobei das Bestimmungsmittel ausgangsseitig mit dem Auswertemittel (4) derart verbunden ist, dass Realteil und Imaginärteil dieses Vektors als Spannungswerte dem Auswertemittel (4) zugeführt werden,
und wobei das Bestimmungsmittel ausgangsseitig auch mit dem Bandpassfiltermittel (3) derart verbunden ist, dass Realteil und Imaginärteil dieses Vektors als Spannungswerte auch einem jeweiligen Bandpassfiltermittel (3) zugeführt werden und die Ausgangssignale des Bandpassfiltermittels (3) ebenfalls dem Auswertemittel (4) zugeführt werden,
- das Bandpassfiltermittel (3) eine steuerbare Mittenfrequenz aufweist, und
- Vergleichsmittel zum Vergleichen der Ausgangssignale des Bandpasses oder der Bandpässe mit einer Komponente des Spannungsraumanzeigers, mit dem Realteil beziehungsweise Imaginärteil, vorgesehen sind,
- wobei die Vergleichsmittel mit den Bestimmungsmitteln zur Bestimmung einer Regelabweichung verbunden sind, die einem Regler zugeführt wird, dessen Stellgröße die Mittenfrequenz des Bandpasses oder der Bandpässe ist.

2. Elektrogerät nach Anspruch 1,
**dadurch gekennzeichnet, dass**
das Netz ein einphasiges Netz oder ein Drehstromnetz ist.

3. Elektrogerät nach mindestens einem der vorangegangenen Ansprüche,
**dadurch gekennzeichnet, dass**
Netzphasenspannungen erfasst werden und jeweiligen Filtern zugeführt werden, deren Ausgangssignale jeweils einer Auswerteeinheit zugeführt werden, der auch die erfassten Netzphasenspannungswerte zugeführt werden.

4. Elektrogerät nach mindestens einem der vorangegangenen Ansprüche,
**dadurch gekennzeichnet, dass**
Bestimmungsmittel zur Bestimmung eines Spannungsraumzeigers aus den erfassten Spannungswerten, der als komplexer Vektor darstellbar ist, vorgesehen sind,
wobei Realteil und Imaginärteil dieses Vektors als Spannungswerte einem jeweiligen Filter zugeführt werden und die Ausgangssignale einer Auswerteeinheit zugeführt werden, der auch der Realteil und Imaginärteil zugeführt werden.

5. Elektrogerät nach mindestens einem der vorangegangenen Ansprüche,
**dadurch gekennzeichnet, dass**
an der dem Netz abgewandten Seite der Induktivität ein oder mehrere Phasenströme erfasst werden,
wobei die erfassten Stromwerte und die erfassten Spannungswerte auch einer Steuerelektronik zugeführt werden, die pulsweitenmodulierte Ansteuersignale erzeugt, die ansteuerbaren Halbleiterschaltern zugeführt werden, welche in einer aus Halbbrücken von Halbleiterschaltern gebildeten Rückspeiseeinheit angeordnet sind.

6. Elektrogerät nach mindestens einem der vorangegangenen Ansprüche,
**dadurch gekennzeichnet, dass**
die rückspeisefähige Versorgungseinheit als Gleichrichter, insbesondere Drehstromgleichrichter, wirksam ist, insbesondere bei Versorgung aus dem Netz,
wobei aus der gleichgerichteten Spannung ein oder mehrere, von der Vorrichtung umfasste Wechselrichter versorgt sind, mit dem oder denen jeweilige Elektromotoren gespeist sind.

7. Elektrogerät nach mindestens einem der vorangegangenen Ansprüche,
**dadurch gekennzeichnet, dass**
zwischen Versorgungseinheit und versorgendem elektrischen Netz ein Netzfilter angeordnet ist, wobei im Netzfilter jeder Netzphase eine als Induktivität wirksame Wicklung zugeordnet ist und die Wicklungen auf einem Kern derart angeordnet sind, dass eine stromkompensierte Netzdrossel gebildet ist.

8. Elektrogerät nach mindestens einem der vorangegangenen Ansprüche,
**dadurch gekennzeichnet, dass**
in der Auswerteeinheit Fehlererkennungsmittel vorgesehen sind, denen die erfassten Spannungssignale und die Ausgangssignale der Filtermittel zugeführt werden.

9. Verfahren zur Fehlererkennung bei einem Elektrogerät nach mindestens einem der vorangegangenen Ansprüche, mit den folgenden Schritte:
- Erfassung der Netzphasenspannungswerte,
- Bestimmen, aus den erfassten Netzphasenspannungswerten, eines netzseitigen Spannungsraumanzeigers, der als komplexer Vektor darstellbar ist,
- Zuführen des Realteils und des Imaginärteils dieses Vektors als Spannungswerte einem Bandpassfilter, dessen Mittenfrequenz steuerbar ist,
- Vergleichen des Ausgangssignals des Bandpassfilters mit dem bestimmten Spannungsraumanzeiger,
- Bestimmen einer Regelabweichung, die von einem Regler auf Null hin geregelt wird, mittels entsprechender Ansteuerung des Bandpassfilters durch den Regler,
wobei
- der bestimmte Spannungsraumanzeiger mit dem als Ausgangssignal der Bandpassfilterung zur Verfügung stehenden Spannungsraumanzeiger verglichen wird und bei Überschreiten einer kritischer Differenz eine Aktion ausgelöst wird,
und/oder
- der bestimmte Spannungsraumanzeiger mit dem als Ausgangssignal der Bandpassfilterung zur Verfügung stehenden Spannungsraumanzeiger einem konsistenzbasierten Auswerteverfahren zugeführt wird.

10. Verfahren nach Anspruch 9,
**dadurch gekennzeichnet, dass**
die Aktion eine Anzeige eines Fehlers, ein Melden eines Fehlers, ein Herausgeben einer Warnung, ein Stillsetzen der Vorrichtung, ein sicheres Abschalten oder ein Herunterfahren der Vorrichtung, ein Aktivieren eines sicheren Zustandes der Vorrichtung oder dergleichen ist.

11. Verfahren nach Anspruch 9 oder 10,
**dadurch gekennzeichnet, dass**
beim steuerbaren Filter eine charakteristische Frequenz als Stellgröße des Reglers steuerbar ist, insbesondere die Mittenfrequenz des als Bandfilter ausgeführten Filters.

12. Verfahren nach Anspruch 9, 11 oder 10,
**dadurch gekennzeichnet, dass**
die Regelabweichung einer Phasendifferenz entspricht.

## Claims

1. Electrical appliance which can be supplied by an AC power network comprising:
- means (2) for detecting the network phase voltage values,
- evaluation means (4) for receiving the network phase voltage values detected by the means (2), and
- bandpass filter means (3) for receiving the network phase voltage values detected by the means (2), the bandpass filter means (3) having a centre frequency,
**characterised in that**
- the electrical appliance is an apparatus with regenerative supply unit, the supply unit being connected to the supplying electrical network via at least one inductor and the network phase voltage being detected on the network side by the inductor,
- the electrical appliance further comprises:
determination means for determining a voltage space vector from the detected network phase voltage values, which can be represented as a complex vector,
the determination means being connected on the output side to the evaluation means (4) in such a manner that real part and imaginary part of this vector are supplied as voltage values to the evaluation means (4),
and the determination means being connected on the output side also to the Bandpass filter means (3) in such a manner that real part and imaginary part of this vector are supplied as voltage values also to a respective bandpass filter means (3) and the output signals of the bandpass filter means (3) are likewise supplied to the evaluation means (4),
- the bandpass filter means (3) has a controllable centre frequency, and
- comparison means for comparing the output signals of the bandpass filter or the bandpass filters with a component of the voltage space vector, with the real part or imaginary part, are provided,
- the comparison means being connected to the determination means for determining a deviation which is supplied to a regulator, the control variable of which is the centre frequency of the bandpass filter or the bandpass filters.

2. Electrical appliance according to claim 1,
**characterised in that**
the network is a single-phase network or a three-phase network.

3. Electrical appliance according to at least one of the preceding claims,
**characterised in that**
network phase voltages are detected and supplied to respective filters, the output signals of which are each supplied to an evaluation unit, which is also supplied with the detected network phase voltage values.

4. Electrical appliance according to at least one of the preceding claims,
**characterised in that**
determination means for determining a voltage space vector from the detected voltage values, which can be represented as a complex vector, are provided,
real part and imaginary part of this vector being supplied as voltage values to a respective filter and the output signals being supplied to an evaluation unit which is also supplied with the real part and imaginary part.

5. Electrical appliance according to at least one of the preceding claims,
**characterised in that**
on the side of the inductor facing away from the network, one or more phase currents are detected,
the detected current values and the detected voltage values also being supplied to control electronics which generate pulse width modulated drive signals which are supplied to drivable semiconductor switches which are arranged in a regenerative unit formed from half-bridges of semiconductor switches.

6. Electrical appliance according to at least one of the preceding claims,
**characterised in that**
the regenerative supply unit is effective as rectifier, in particular three-phase rectifier, in particular when supplied from the network,
one or more inverters comprised by the apparatus being supplied from the rectified voltage, with which inverter or inverters respective electric motors are fed.

7. Electrical appliance according to at least one of the preceding claims,
**characterised in that**
a network filter is arranged between supply unit and supplying electrical network, a winding effective as inductor being assigned in the network filter to each network phase and the windings being arranged on a core in such a manner that a current-compensated network choke is formed.

8. Electrical appliance according to at least one of the preceding claims,
**characterised in that**
fault detection means are provided in the evaluation unit, to which means the detected voltage signals and the output signals of the filter means are supplied.

9. Method for fault detection in an electrical appliance according to at least one of the preceding claims having the following steps:
- detection of the network phase voltage values,
- determining, from the detected network phase voltage values, a network-side voltage space vector which can be represented as a complex vector,
- supplying the real part and the imaginary part of this vector as voltage values to a bandpass filter, the centre frequency of which is controllable,
- comparing the output signal of the bandpass filter with the determined voltage space vector,
- determining a deviation which is regulated by a regulator towards zero, by means of appropriate driving of the bandpass filter by the regulator,
- the determined voltage space vector being compared with the voltage space vector available as output signal of the bandpass filtering and, if a critical difference is exceeded, an action being triggered,
and/or
- the determined voltage space vector with the voltage space vector available as output signal of the bandpass filtering being supplied to a consistency-based evaluation method.

10. Method according to claim 9,
**characterised in that**
the action is an indication of a fault, reporting an error, issuing a warning, stopping the apparatus, a safe switch-off or a shutdown of the apparatus, activating a safe state of the apparatus or the like.

11. Method according to claim 9 or 10,
**characterised in that**
in the controllable filter a characteristic frequency is controllable as control variable of the regulator, in particular the centre frequency of the filter realised as band filter.

12. Method according to claim 9, 11 or 10,
**characterised in that**
the deviation corresponds to a phase difference.

## Revendications

1. Appareil électrique pouvant être alimenté à partir d'un réseau électrique à courant alternatif, comprenant :
- un moyen (2) pour détecter les valeurs de tension de phase de réseau,
- un moyen d'évaluation (4) pour recevoir les valeurs de tension de phase de réseau détectées avec le moyen (2), et
- un moyen de filtrage passe-bande (3) pour recevoir les valeurs de tension de phase de réseau détectées avec le moyen (2), lequel moyen de filtrage passe-bande (3) présente une fréquence centrale,
**caractérisé en ce que**
- l'appareil électrique est un dispositif avec unité d'alimentation apte à la réinjection sur le réseau, l'unité d'alimentation étant reliée au réseau électrique d'alimentation par au moins une inductance et la tension de phase de réseau côté réseau étant détectée par l'inductance,
- l'appareil électrique comprend en outre :
un moyen de détermination pour déterminer, à partir des valeurs de tension de phase de réseau détectées, un vecteur spatial de tension qui peut être représenté sous la forme d'un vecteur complexe,
le moyen de détermination étant relié côté sortie au moyen d'évaluation (4) de façon que la partie réelle et la partie imaginaire de ce vecteur soient amenées en tant que valeurs de tension au moyen d'évaluation (4),
et le moyen de détermination étant relié côté sortie aussi au moyen de filtrage passe-bande (3) de façon que la partie réelle et la partie imaginaire de ce vecteur soient amenées en tant que valeurs de tension aussi à un moyen de filtrage passe-bande (3) respectif et les signaux de sortie du moyen de filtrage passe-bande (3) étant également amenés au moyen d'évaluation (4),
- le moyen de filtrage passe-bande (3) présente une fréquence centrale commandable, et
- des moyens de comparaison pour comparer les signaux de sortie du ou des passe-bande avec une composante du vecteur spatial de tension, avec la partie réelle, respectivement la partie imaginaire, sont prévus,
- les moyens de comparaison étant reliés aux moyens de détermination pour déterminer un écart de régulation qui est amené à un régulateur dont la grandeur réglante est la fréquence centrale du ou des passe-bande.

2. Appareil électrique selon la revendication 1,
**caractérisé en ce**
**que** le réseau est un réseau monophasé ou un réseau triphasé.

3. Appareil électrique selon au moins l'une des revendications précédentes,
**caractérisé en ce**
**que** des tensions de phase de réseau sont détectées et amenées à des filtres respectifs dont les signaux de sortie sont amenés chaque fois à une unité d'évaluation à laquelle sont aussi amenées les valeurs de tension de phase de réseau détectées.

4. Appareil électrique selon au moins l'une des revendications précédentes,
**caractérisé en ce**
**que** des moyens de détermination pour déterminer, à partir des valeurs de tension détectées, un vecteur spatial de tension qui peut être représenté sous la forme d'un vecteur complexe, sont prévus,
la partie réelle et la partie imaginaire de ce vecteur étant amenées en tant que valeurs de tension à un filtre respectif et les signaux de sortie étant amenés à une unité d'évaluation à laquelle sont aussi amenées la partie réelle et la partie imaginaire.

5. Appareil électrique selon au moins l'une des revendications précédentes,
**caractérisé en ce**
**qu'**un ou plusieurs courants de phase sont détectés du côté de l'inductance éloigné du réseau,
les valeurs de courant détectées et les valeurs de tension détectées étant aussi amenées à une électronique de commande qui génère des signaux de commande modulés en largeur d'impulsion qui sont amenés à des commutateurs à semi-conducteurs commandables, lesquels sont disposés dans une unité de réinjection sur le réseau formée de demi-ponts de commutateurs à semi-conducteurs.

6. Appareil électrique selon au moins l'une des revendications précédentes,
**caractérisé en ce**
**que** l'unité d'alimentation apte à la réinjcction sur le réseau fonctionne comme redresseur, en particulier redresseur triphasé, en particulier en cas d'alimentation à partir du réseau,
un ou plusieurs onduleurs compris par le dispositif, par lequel ou lesquels des moteurs électriques respectifs sont alimentés, étant alimentés à partir de la tension redressée.

7. Appareil électrique selon au moins l'une des revendications précédentes,
**caractérisé en ce**
**qu'**un filtre réseau est disposé entre l'unité d'alimentation et le réseau électrique d'alimentation, un enroulement fonctionnant comme inductance étant associé à chaque phase de réseau dans le filtre réseau et les enroulements étant disposés sur un noyau de façon à former une self réseau compensée en courant.

8. Appareil électrique selon au moins l'une des revendications précédentes,
**caractérisé en ce**
**que** des moyens de détection de défaut sont prévus dans l'unité d'évaluation, auxquels les signaux de tension détectés et les signaux de sortie des moyens de filtrage sont amenés.

9. Procédé de détection de défaut pour un appareil électrique selon au moins l'une des revendications précédentes,
comprenant les étapes suivantes :
- détection des valeurs de tension de phase de réseau,
- détermination, à partir des valeurs de tension de phase de réseau détectées, d'un vecteur spatial de tension côté réseau qui peut être représenté sous la forme d'un vecteur complexe,
- amenée de la partie réelle et de la partie imaginaire de ce vecteur en tant que valeurs de tension à un filtre passe-bande dont la fréquence centrale est commandable,
- comparaison du signal de sortie du filtre passe-bande avec le vecteur spatial de tension déterminé,
- détermination d'un écart de régulation qui est ramené à zéro par un régulateur par commande correspondante du filtre passe-bande par le régulateur,
dans lequel
- le vecteur spatial de tension déterminé est comparé avec le vecteur spatial de tension disponible comme signal de sortie du filtrage passe-bande et, en cas de dépassement d'une différence critique, une action est déclenchée,
et/ou
- le vecteur spatial de tension déterminé est amené avec le vecteur spatial de tension disponible comme signal de sortie du filtrage passe-bande à un procédé d'évaluation à base de cohérence.

10. Procédé selon la revendication 9,
**caractérisé en ce**
**que** l'action est un affichage d'un défaut, une signalisation d'un défaut, une émission d'un avertissement, une immobilisation du dispositif, une déconnexion sécurisée ou un arrêt du dispositif, une activation d'un état sécurisé du dispositif ou analogue.

11. Procédé selon la revendication 9 ou 10,
**caractérisé en ce**
**que** pour le filtre commandable, une fréquence caractéristique peut être commandée en tant que grandeur réglante du régulateur, en particulier la fréquence centrale du filtre réalisé comme filtre passe-bande.

12. Procédé selon la revendication 9, 11 ou 10,
**caractérisé en ce**
**que** l'écart de régulation correspond à une différence de phase.
